(19) **Europäisches Patentamt European Patent Office Office européen des brevets**

(11) **EP 4 773 463 A1**

(12) **EUROPEAN PATENT APPLICATION**
published in accordance with Art. 153(4) EPC

(43) Date of publication:
08.07.2026 Bulletin 2026/28

(51) International Patent Classification (IPC):
$H02J\ 7/00^{(2026.01)}$  $G01R\ 31/3835^{(2019.01)}$
$G01R\ 31/389^{(2019.01)}$  $H01M\ 10/44^{(2006.01)}$

(21) Application number: 25816176.9

(22) Date of filing: 16.04.2025

(52) Cooperative Patent Classification (CPC):
G01R 31/3835; G01R 31/389; H01M 10/44;
H02J 7/00; Y02E 60/10

(86) International application number:
PCT/KR2025/005165

(87) International publication number:
WO 2025/249762 (04.12.2025 Gazette 2025/49)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 27.05.2024 KR 20240068449

(71) Applicant: LG Energy Solution, Ltd.
Seoul 07335 (KR)

(72) Inventors:
• YOON, Yeo Kyung
Daejeon 34122 (KR)
• KIM, Yu Joong
Daejeon 34122 (KR)

(74) Representative: Hoffmann Eitle
Patent- und Rechtsanwälte PartmbB
Arabellastraße 30
81925 München (DE)

(54) **BATTERY MANAGEMENT SYSTEM, BATTERY PACK INCLUDING SAME, AND METHOD OF ESTABLISHING CHARGING PROTOCOL OF LITHIUM SECONDARY BATTERY**

(57) A method for establishing a charging protocol for a lithium secondary battery and a battery management system according to the present invention include a measurement unit configured to measure a closed circuit voltage ($CCV_{SOCy}$) and an open circuit voltage ($OCV_{SOCy}$), with respect to a state of charge (SOCy) during charging with each of different charging currents (I), for a two-electrode battery cell including a positive electrode and a negative electrode; a memory unit configured to collect and store an internal resistance profile obtained by calculating an internal compensated resistance value ($R_{rest3-0.1s}$) with respect to the state of charge by substituting the measured $CCV_{SOCy}$ and $OCV_{SOCy}$ into Equation 1, and by plotting the internal compensated resistance value ($R_{rest3-0.1s}$) with respect to the state of charge for each charging current (I); and a control unit configured to determine, from the internal resistance profile, limit states of charge each corresponding to each charging current, and to establish a charging protocol based thereon.

[Figure 3]

START

(a) PROCESS OF MEASURING CLOSED CIRCUIT VOLTAGE AND OPEN CIRCUIT VOLTAGE, WITH RESPECT TO STATE OF CHARGE DURING CHARGING WITH EACH OF DIFFERENT CHARGING CURRENTS, FOR TWO-ELECTRODE BATTERY CELL INCLUDING POSITIVE ELECTRODE AND NEGATIVE ELECTRODE

(b) PROCESS OF COLLECTING INTERNAL RESISTANCE PROFILE OBTAINED BY CALCULATING INTERNAL RESISTANCE VALUE WITH RESPECT TO STATE OF CHARGE BY SUBSTITUTING MEASURED CLOSED CIRCUIT VOLTAGE AND OPEN CIRCUIT VOLTAGE INTO EQUATION 1, AND BY PLOTTING INTERNAL RESISTANCE VALUE WITH RESPECT TO STATE OF CHARGE FOR EACH CHARGING CURRENT

(c) PROCESS OF DETERMINING, FROM COLLECTED INTERNAL RESISTANCE PROFILE, LIMIT STATES OF CHARGE EACH CORRESPONDING TO EACH CHARGING CURRENT.

Finish

**Description**

[Technical Field]

This application claims priority to and the benefit of Korean Patent Application No. 10-2024-0068449 filed in the Korean Intellectual Property Office on May 27, 2024, the entire contents of which are incorporated herein by reference.
The present invention relates to a method for establishing a rapid charging protocol that reflects heat generation and internal resistance due to charging and discharging of a large-capacity battery cell, a battery management system capable of establishing such a rapid charging protocol, and a battery pack including the same.

[Background Art]

In recent years, the demand for portable electronic products such as laptops and portable phones is increasing dramatically, and the demand for electric carts, electric wheelchairs, and electric bicycles is also increasing, and accordingly, research on high-performance batteries that can be repeatedly charged and discharged is actively being conducted. In addition, the demand for hybrid electric vehicles (HEVs) and electric vehicles (EVs) is recently increasing worldwide as carbon energy is gradually depleting and environmental concerns are rising. As a result, more attention and research are being focused on vehicle batteries, which are key components of HEVs and EVs, and the development of rapid charging technology that enables rapid charging of batteries is also urgently needed. Rapid charging is a critical capability, especially for EVs that do not have an additional energy source.
The process of charging a battery involves introducing current into the battery to build up charges and energy, and this process needs to be carefully controlled. In general, excessive charging current (C-rate) or charging voltage can permanently degrade the performance of a battery and ultimately cause complete failure, or an unexpected failure such as leakage or explosion of highly corrosive chemicals.
When charging a battery with a constant current, if the current rate of the charging current is low, a very long time is required to fully charge the battery. On the other hand, if the current rate of the charging current is excessively high, a side effect occurs in which the battery rapidly deteriorates (aged). Therefore, during constant current charging, it is necessary to adjust the current rate of the charging current in a stepwise manner in accordance with the state of the battery.
A charge map with a "multi-stage constant-current charging protocol" is often utilized to adjust the current rate in a stepwise manner during constant current charging. The charge map includes at least one data array in which a relationship between a plurality of current rates and a plurality of switching conditions is recorded. Each time each switching condition is satisfied, the following sequence of current rates may be supplied to the battery as charging current. A current rate (which may also be referred to as a 'C-rate') is a value obtained by dividing the charging current by the maximum capacity of the battery, and uses 'C' as its unit.
In the related art, to derive such a multi-stage constant-current charging protocol, a monocell-type three-electrode cell with a capacity of about 50 mAh was fabricated, and the state of charge (SOC) at which lithium plating occurs on the negative electrode for each charging current was established as the charging limit.
However, the three-electrode cell is difficult to fabricate and requires a dedicated charger/discharger to charge and discharge, so there are many constraints such as the fabrication completeness of the three-electrode cell, the fabrication time of the three-electrode cell, and the preparation of the dedicated charger/discharger. When applying the limit state of charge identified in such a three-electrode cell to large-capacity battery cells with capacities of about 40 to 200 Ah, there is no technology that reflects the resistance of large-capacity battery cells or heat generation during rapid charging. In addition, in the method of establishing a charging protocol using a three-electrode cell, as the charging current decreases and the negative electrode composition becomes more favorable for rapid charging, it becomes difficult to clearly distinguish the lithium plating region, allowing the experimenter's subjectivity to intervene. Consequently, when there are variations among battery cells, it is difficult to establish a charging protocol that exhibits similar voltage profiles.
Recognizing the above problems, a method for establishing a charging protocol based on the fabrication of a two-electrode cell was developed. However, as the mixed use of silicon-based active materials (such as SiC and SiO) in negative electrodes has recently increased in order to enhance rapid charging and capacity characteristics, the cell resistance has decreased, and furthermore, in situations such as high C-rate charging, cases are increasingly arising in which it is difficult to derive the state of charge through analysis methods for two-electrode cells. In addition, as the positive electrode material changes according to the application of the cell, for example from a High-Ni 4.2V cell to a Mid-Ni 4.35V cell, additional cases arise in which analysis becomes more difficult.
Therefore, in accordance with recent trends in cells, there is a need to develop a technology that, while taking into account the resistance of large-capacity battery cells and heat generation during rapid charging, derives a charging protocol that enables charging with a high current during rapid charging, for example by using silicon-based active materials in the negative electrode or Mid-Ni active materials in the positive electrode, and that can exhibit similar voltage profiles even when there are variations among battery cells.

Prior Art Document

Korean Patent Application Publication No. 10-2017-0021630

[Detailed Description of the Invention]

[Technical Problem]

The present invention has been made to solve the above problems, and relates to a battery management system and a method for establishing a charging protocol for a lithium secondary battery, which do not require fabrication of a three-electrode cell in advance for deriving a limit state of charge for each charging current, and can be applied even in situations such as the use of a Mid-Ni active material in a positive electrode and the mixed use of a silicon-based active material (such as SiC and SiO) in a negative electrode in order to enhance rapid charging and capacity characteristics, or high C-rate charging during charging.

[Technical Solution]

According to an exemplary embodiment of the present invention, there is provided a battery management system including a measurement unit configured to measure a closed circuit voltage ($CCV_{SOCy}$) and an open circuit voltage ($OCV_{SOCy}$), with respect to a state of charge (SOCy) during charging with each of different charging currents (I), for a two-electrode battery cell including a positive electrode and a negative electrode; a memory unit configured to collect and store an internal resistance profile obtained by calculating an internal compensated resistance value ($R_{rest3-0.1s}$) with respect to the state of charge by substituting the measured closed circuit voltage ($CCV_{SOCy}$) and open circuit voltage ($OCV_{SOCy}$) into Equation 1, and by plotting the internal compensated resistance value ($R_{rest3-0.1s}$) with respect to the state of charge for each charging current (I); and a control unit configured to determine, from the internal resistance profile, limit states of charge each corresponding to each charging current, and to establish a charging protocol based thereon.

[Equation 1]

$$R_{rest\,3-0.1s}\,(R_{diff}) = R_{rest\,3s}\,(R_{total}) - R_{rest\,0.1s}\,(R_{ohmic})$$

Equation 1 represents resistance values respectively calculated when charging is performed in a pattern in which the battery cell is charged at a C-rate of x at 25°C based on SOC y% of capacity, followed by a rest period of 3 seconds (OCVSOCy) after charging to SOC y% (CCVSOCy),

the x is 0.1C or more and 8.0C or less,
the y is 0 or more and 100 or less,
the $R_{rest\,3s}$ is a resistance value after a rest period of 3 seconds (OCVSOCy) after charging to SOC y% (CCVSOCy), and
the $R_{rest\,0.1s}$ is a resistance value after a rest period of 0.1 seconds (OCVSOCy) after charging to SOC y% (CCVSOCy).

Another exemplary embodiment is intended to provide a battery pack including the battery management system.
Finally, a method for establishing a charging protocol for a lithium secondary battery is provided which includes (a) measuring a closed circuit voltage ($CCV_{SOCy}$) and an open circuit voltage ($OCV_{SOCy}$), with respect to a state of charge (SOCy) during charging with each of different charging currents (I), for a two-electrode battery cell including a positive electrode and a negative electrode; (b) collecting an internal resistance profile obtained by calculating an internal compensated resistance value ($R_{rest3-0.1s}$) with respect to the state of charge by substituting the measured closed circuit voltage ($CCV_{SOCy}$) and open circuit voltage ($OCV_{SOCy}$) into Equation 1, and by plotting the internal compensated resistance value ($R_{rest3-0.1s}$) with respect to the state of charge for each charging current (I); and (c) determining, from the collected internal resistance profile, limit states of charge each corresponding to each charging current.

[Equation 1]

$$R_{\text{rest } 3\text{-}0.1s} \, (R_{\text{diff}}) = R_{\text{rest } 3s} \, (R_{\text{total}}) - R_{\text{rest } 0.1s} \, (R_{\text{ohmic}})$$

Equation 1 represents resistance values respectively calculated when charging is performed in a pattern in which the battery cell is charged at a C-rate of x at 25°C based on SOC y% of capacity, followed by a rest period of 3 seconds (OCVSOCy) after charging to SOC y% (CCVSOCy),

the x is 0.1C or more and 8.0C or less,
the y is 0 or more and 100 or less,
the $R_{\text{rest } 3s}$ is a resistance value after a rest period of 3 seconds (OCVSOCy) after charging to SOC y% (CCVSOCy), and
the $R_{\text{rest } 0.1s}$ is a resistance value after a rest period of 0.1 seconds (OCVSOCy) after charging to SOC y% (CCVSOCy).

[Advantageous Effects]

The battery management system and charging protocol setting method according to the present invention have the effect of providing a charging protocol in which resistance and heat generation are reflected directly from a large-capacity battery cell without the need to fabricate a three-electrode cell, which is cumbersome to fabricate.

In addition, the battery management system and charging protocol setting method according to the present invention have the effect of non-destructively identifying the degree of deterioration of a battery cell even during operation of the battery cell, and updating the charging protocol by reflecting the deterioration of the battery cell.

In addition, the battery management system and charging protocol setting method according to the present invention can derive a limit state of charge even at a low charging current at the level of 1.0C, thereby providing a charging protocol favorable for rapid charging.

In addition, the present invention has a feature in that it is not necessary to fabricate a three-electrode cell in advance for deriving a limit state of charge for each charging current, and that the limit state of charge can be derived even in situations such as the use of a Mid-Ni active material in a positive electrode for ensuring safety, including suppression of thermal propagation (TP), the mixed use of a silicon-based active material (such as SiC and SiO) in a negative electrode for enhancing rapid charging and capacity characteristics, or high C-rate charging during charging.

[Brief Description of Drawings]

FIG. 1 is a diagram showing an exemplary configuration of a battery pack including a battery management system according to an exemplary embodiment of the present invention.
FIG. 2 is a diagram schematically illustrating the battery pack including the battery management system according to an exemplary embodiment of the present invention.
FIG. 3 is a flowchart of a method for establishing a charging protocol for a lithium secondary battery according to an exemplary embodiment of the present invention.
FIG. 4 is a diagram showing the shape of a graph in an internal resistance profile with respect to the state of charge of Comparative Example 1.
FIG. 5 is a diagram showing the shape of a graph in an internal resistance profile with respect to the state of charge of Example 1.
FIG. 6 is a diagram showing the shape of a graph in an internal resistance profile with respect to the state of charge of Reference Example 2.
FIG. 7 is a diagram showing the shape of a graph in an internal resistance profile with respect to the state of charge of Example 2.
FIG. 8 is a diagram schematically showing a method of performing a QC cycle.
FIG. 9 is a diagram showing QC cycles for batteries of Preparation Examples 1 and 2.
FIG. 10 is a diagram showing the shape of a graph in internal resistance profiles according to the state of charge for a deteriorated cell and a fresh cell of Preparation Example 1.
FIG. 11 is a diagram showing voltage behaviors at 2C for explaining IR Drop.

<Explanation of Reference Numerals and Symbols>

    1: battery pack
    10: battery Cell
    100: battery management system
    110: measurement unit
    120: memory unit
    130: control unit
    200: charging device

[Best Mode]

It should be understood that the terms or words used in the present specification and claims should not be construed as being limited to their general and dictionary meanings, but should be construed in accordance with the meanings and concepts consistent with technical spirit of the present invention, based on the principle that the inventor is allowed to define terms appropriately for the best explanation.

Accordingly, it should be understood that the exemplary embodiments described herein and the configurations illustrated in the drawings are only the most preferred exemplary embodiments of the present invention and do not represent all of the technical ideas of the present invention, and that there may be various equivalents and variations that may be substituted for them at the time of filing the application.

In addition, in describing the present invention, detailed descriptions of related known configurations or features are omitted when it is determined that such detailed descriptions would obscure the essence of the present invention.

Throughout the specification, unless explicitly described to the contrary, the word "comprise (include)", and variations such as "comprises (includes)" or "comprising (including)", will be understood to imply the inclusion of stated elements but not the exclusion of any other elements.

In addition, terms such as control unit as used in the specification refer to a unit that handles at least one function or operation, which may be implemented in hardware or software, or a combination of hardware and software.

In addition, throughout the specification, when a part is described as being "connected" to another part, this includes not only being "directly connected" but also being "indirectly connected" with one or more intervening elements.

Hereinafter, preferred exemplary embodiments of the present invention will be described in detail with reference to the accompanying drawings.

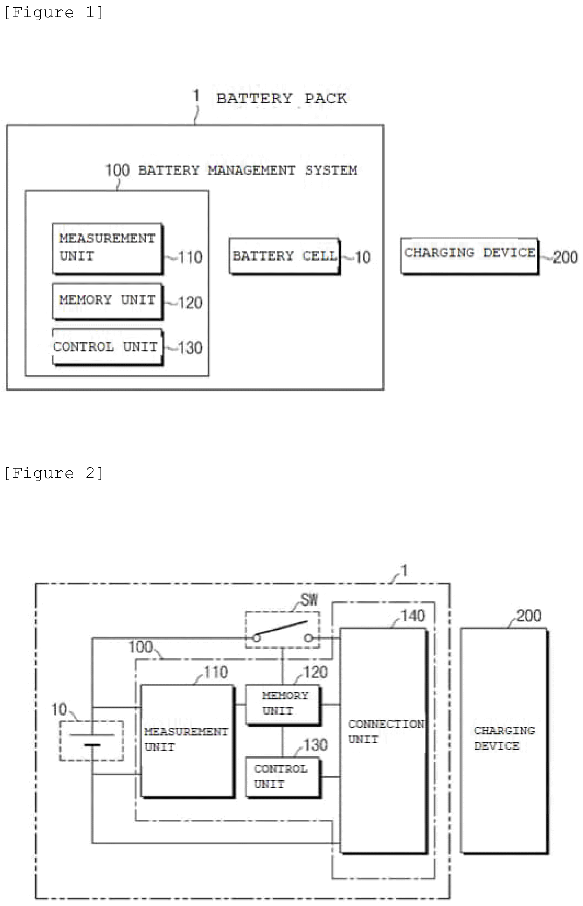

FIG. 1 is a diagram showing an exemplary configuration of a battery pack including a battery management system according to an exemplary embodiment of the present invention. FIG. 2 is a diagram schematically illustrating the battery pack including the battery management system according to an exemplary embodiment of the present invention.

Referring to FIG. 1, a battery pack 1 may include a battery cell 10 and a battery management system 100. The battery management system 100 is a battery management system that monitors the voltage, current, temperature, and the like of the battery cell 10 and controls and manages the battery cell to prevent overcharging and overdischarging.

Here, the battery cell 10 is a two-electrode battery cell having a negative electrode and a positive electrode, and refers to a single, physically separable independent cell. As an example, one pouch-type lithium polymer cell may be considered as the battery cell 10. The battery cell 10 may be a large-capacity battery cell having a capacity at a level of 40 to 200 Ah.

Additionally, the battery pack 1 may include a battery module with one or more battery cells 10 connected in series and/or in parallel.

The positive electrode may include a positive electrode current collector and a positive electrode active material layer formed on the positive electrode current collector and including the positive electrode active material.

In the positive electrode, the positive electrode current collector is not particularly limited as long as it has conductivity without causing a chemical change in the battery. For example, stainless steel, aluminum, nickel, titanium, fired carbon, aluminum or stainless steel each surface-treated with carbon, nickel, titanium, silver, or the like, or the like may be used. In addition, the positive electrode current collector may typically have a thickness of 3 to 500 $\mu$m, and a surface of the current collector may be formed with microscopic irregularities to enhance adhesive force of the positive electrode active material. For example, the positive electrode current collector may be used in various forms such as a film, a sheet, a foil, a net, a porous body, a foamed body, and a non-woven fabric body.

The positive electrode active material may be a positive electrode active material that is typically used. Specifically, the positive electrode active material may be a layered compound such as a lithium cobalt oxide ($LiCoO_2$) and a lithium nickel oxide ($LiNiO_2$), or a compound substituted with one or more transition metals; a lithium iron oxide such as $LiFe_3O_4$; a lithium manganese oxide represented by chemical formula $Li_{1+c1}Mn_{2-c1}O_4$ ($0 \leq c1 \leq 0.33$), $LiMnO_3$, $LiMn_2O_3$

and $LiMnO_2$; a lithium copper oxide ($Li_2CuO_2$); a vanadium oxide such as $LiV_3O_8$, $V_2O_5$, and $Cu_2V_2O_7$; a Ni-site type lithium nickel oxide represented by chemical formula $LiNi_{1-c2}M_{c2}O_2$ (where M is at least one selected from the group consisting of Co, Mn, Al, Cu, Fe, Mg, B, and Ga, and satisfies $0.01 \leq c2 \leq 0.3$); a lithium manganese composite oxide represented by chemical formula $LiMn_{2-c3}M_{c3}O_2$ (where M is at least one selected from the group consisting of Co, Ni, Fe, Cr, Zn, and Ta, and satisfies $0.01 \leq c3 \leq 0.1$) or $Li_2Mn_3MO_8$ (where M is at least one selected from the group consisting of Fe, Co, Ni, Cu, and Zn); $LiMn_2O_4$ in which a part of Li of the chemical formula is substituted with an alkaline earth metal ion, or the like, but is not limited thereto. The positive electrode may be Li metal.

The positive electrode active material layer may include a positive electrode conductive material and a positive electrode binder together with the positive electrode active material described above.

In this case, the positive electrode conductive material is used to impart conductivity to the electrode, and can be used without particular limitation as long as the positive electrode conductive material has electronic conductivity without causing a chemical change in a battery to be constituted. Specific examples may include graphite such as natural graphite and artificial graphite; a carbon-based material such as carbon black, acetylene black, Ketjen black, channel black, furnace black, lamp black, thermal black and carbon fiber; metal powders or metal fibers such as copper, nickel, aluminum and silver; a conductive whisker such as zinc oxide and potassium titanate; a conductive metal oxide such as titanium oxide; or a conductive polymer such as polyphenylene derivative, or the like, and any one thereof or a mixture of two or more thereof may be used.

In addition, the positive electrode binder serves to improve bonding between particles of the positive electrode active material and adhesive force between the positive electrode active material and the positive electrode current collector. Specific examples may include polyvinylidene fluoride (PVDF), vinylidene fluoride-hexafluoropropylene copolymer (PVDF-co-HFP), polyvinyl alcohol, polyacrylonitrile, carboxymethylcellulose (CMC), starch, hydroxypropylcellulose, regenerated cellulose, polyvinylpyrrolidone, tetrafluoroethylene, polyethylene, polypropylene, ethylene-propylene-diene polymer (EPDM), sulfonated-EPDM, styrene butadiene rubber (SBR), fluoro rubber, or various copolymers thereof, and the like, and any one thereof or a mixture of two or more thereof may be used.

In an exemplary embodiment of the present application, the negative electrode may include a negative electrode current collector layer; and a negative electrode active material layer including a negative electrode composition or a cured product thereof formed on one surface or both surfaces of the negative electrode current collector layer.

In an exemplary embodiment of the present application, the negative electrode current collector layer generally has a thickness of 1 μm to 100 μm. Such a negative electrode current collector layer is not particularly limited as long as it has high conductivity without causing a chemical change in the battery. For example, copper, stainless steel, aluminum, nickel, titanium, fired carbon, copper or stainless steel each surface-treated with carbon, nickel, titanium, silver, or the like, an aluminum-cadmium alloy, or the like may be used. In addition, the negative electrode current collector layer may have microscopic irregularities formed on a surface to enhance a bonding force of the negative electrode active material, and may be used in various forms such as a film, a sheet, a foil, a net, a porous body, a foamed body, or a non-woven fabric body.

In an exemplary embodiment of the present application, a thickness of the negative electrode current collector layer may be 1 μm or more and 100 μm or less, and a thickness of the negative electrode active material layer may be 5 μm or more and 500 μm or less.

However, the thickness may be variously modified depending on a type and a use of negative electrode used, and is not limited thereto.

In the present application, the negative electrode composition may include at least one selected from the group consisting of a negative electrode active material, a negative electrode conductive material, and a negative electrode binder.

In the present application, the negative electrode active material may include one or more selected from the group consisting of a carbon-based active material, a silicon-based active material, a metal-based active material capable of alloying with lithium, and a lithium-containing nitride.

In the present application, the carbon-based active material may include a carbon-based material such as graphite or activated carbon.

In an exemplary embodiment of the present application, representative examples of the carbon-based active material include natural graphite, artificial graphite, expandable graphite, carbon fiber, non-graphitizable carbon, carbon black, carbon nanotubes, fullerene, activated carbon, or the like, and the carbon-based active material can be used without limitation as long as the carbon-based active material is typically used in a carbon material for a lithium secondary battery, and specifically may be processed into a spherical or point-like shape and used.

In an exemplary embodiment of the present application, the carbon-based active material includes graphite, the graphite includes artificial graphite and natural graphite, and the weight ratio of the artificial graphite and natural graphite may be 5:5 to 9.5:0.5.

The artificial graphite according to an exemplary embodiment of the present invention may be in the form of initial particles, or may be in the form of secondary particles in which the plurality of initial particles are agglomerated.

As used in the present invention, the term "initial particle" refers to an original particle when a different type of particle is formed from a certain particle, and a plurality of initial particles may be clustered, bonded, or assembled to form a secondary particle.

As used in the present invention, the term "secondary particle" refers to a large physically distinguishable particle formed by clustering, bonding or assembling individual initial particles.

The artificial graphite of the initial particle may be manufactured by heat-treating one or more selected from the group consisting of needle cokes, mosaic cokes and coal tar pitch.

The artificial graphite is generally manufactured by carbonizing raw materials such as coal tar, coal tar pitch and petroleum-based heavy oil to 2,500°C or higher, and after such graphitization, the artificial graphite may be subjected to particle size adjustment such as pulverization and formation of secondary particles and then used as a negative electrode active material. In the case of artificial graphite, the crystals are randomly distributed in the particles, the circularity is lower than that of natural graphite, and the shape is slightly sharp.

Examples of the artificial graphite used in an exemplary embodiment of the present invention include mesophase carbon microbeads (MCMB) and mesophase pitch-based carbon fiber (MPCF), which are commercially widely used, artificial graphite graphitized in block form, artificial graphite graphitized in powder form, and the like. The artificial graphite may have a circularity (sphericity) of 0.91 or less, or 0.6 to 0.91, or 0.7 to 0.9.

Additionally, the artificial graphite may have a particle diameter of 5 to 30 $\mu$m, preferably 10 to 25 $\mu$m.

Specifically, the artificial graphite initial particles may have a D50 of 6 $\mu$m to 15 $\mu$m, 6 $\mu$m to 10 $\mu$m, or 6 $\mu$m to 9 $\mu$m. When the D50 of the initial particle satisfies such a range, the initial particle may be formed so as to have high graphitization, the orientation index of the negative electrode active material particle is appropriately secured, so that the rapid charging performance can be improved.

The artificial graphite secondary particle may be formed by assembly of initial particles. That is, the secondary particle may be a structure formed by agglomeration of the initial particles with each other through an assembling process. The secondary particle may include a carbonaceous matrix that causes the initial particles to be agglomerated. The carbonaceous matrix may include at least one of soft carbon and graphite. The soft carbon may be formed by heat treatment of pitch.

The carbonaceous matrix may be included in the secondary particle in an amount of 8 wt% to 16 wt%, specifically 9 wt% to 12 wt%. This range is lower than the content of a carbonaceous matrix that is used in typical artificial graphite secondary particles. In this range, the particle size of the initial particles in the secondary particle is controlled, so that structurally stable secondary particles may be manufactured even with a small amount of carbonaceous matrix required for assembly, and the amount of initial particles constituting the secondary particles may also be uniform.

A surface of the artificial graphite secondary particle may include a carbon coating layer, and the carbon coating layer may include at least one of amorphous carbon and crystalline carbon.

The crystalline carbon may further enhance conductivity of the negative electrode active material. The crystalline carbon may include at least one selected from the group consisting of fullerene and graphene.

The amorphous carbon may appropriately maintain the strength of the coating layer to suppress expansion of the natural graphite. The amorphous carbon may be a carbon-based material formed using at least one carbide selected from the group consisting of tar, pitch, and other organic materials, or a hydrocarbon as a source of a chemical vapor deposition method.

The carbide of the other organic materials may be a carbide of sucrose, glucose, galactose, fructose, lactose, mannose, ribose, aldohexose or ketohexose and a carbide of an organic material selected from combinations thereof.

The artificial graphite secondary particles may have a D50 of 10 $\mu$m to 25 $\mu$m, specifically 12 $\mu$m to 22 $\mu$m, and more specifically 13 $\mu$m to 20 $\mu$m. When the above range is satisfied, the artificial graphite secondary particles may be uniformly dispersed in the slurry, and the charging performance of a battery may also be improved.

The artificial graphite secondary particle may have a tap density of 0.85 g/cc to 1.30 g/cc, specifically 0.90 g/cc to 1.10 g/cc, and more specifically 0.90 g/cc to 1.07 g/cc. When the above range is satisfied, packing of artificial graphite secondary particles may be smoothly performed in the negative electrode, which means that the negative electrode adhesive force may be improved.

The natural graphite may be generally in the form of plate-like agglomerates before being processed, and the plate-like particles may be manufactured in the form of a sphere having a smooth surface through post-treatment processing such as particle pulverization and re-assembly process for use as an active material for manufacture of an electrode.

The natural graphite used in an exemplary embodiment of the present invention may have a circularity of greater than 0.91 and 0.97 or less, 0.93 to 0.97, or 0.94 to 0.96.

The natural graphite may have a particle diameter of 5 to 30 $\mu$m, or 10 to 25 $\mu$m.

According to an exemplary embodiment of the present invention, a weight ratio of the artificial graphite and the natural graphite may be 5:5 to 9.5:0.5, or 5:5 to 9.3:0.7, or 5:5 to 9:1, or 6:4 to 9:1. When the weight ratio of the artificial graphite and the natural graphite falls within such a range, better output may be exhibited, which may be advantageous in terms of life and rapid charging performance.

In the present application, the silicon-based active material may include one or more selected from the group consisting of SiOx (x=0), SiOx (0<x<2), SiC, and a Si alloy.

In the present application, the silicon-based active material may include SiC.

In the present application, the negative electrode active material may include a carbon-based active material and a silicon-based active material.

In the present application, the silicon-based active material may be included in an amount of 50 parts by weight or less, preferably 40 parts by weight or less, and specifically 30 parts by weight or less, and 1 part by weight or more and 3 parts by weight or more, based on 100 parts by weight of the negative electrode active material.

In an exemplary embodiment of the present application, the negative electrode conductive material may include one or more selected from the group consisting of a point-like conductive material, a planar conductive material, and a linear conductive material.

In an exemplary embodiment of the present application, the point-like conductive material refers to a point-like or spherical conductive material that may be used for improving conductivity of the negative electrode and has conductivity without causing a chemical change. Specifically, the point-like conductive material may be at least one selected from the group consisting of natural graphite, artificial graphite, carbon black, acetylene black, Ketjen black, channel black, furnace black, lamp black, thermal black, conductive fiber, fluorocarbon, aluminum powder, nickel powder, zinc oxide, potassium titanate, titanium oxide, and a polyphenylene derivative, and preferably may include carbon black in terms of high conductivity and excellent dispersibility.

In an exemplary embodiment of the present application, the planar conductive material may include at least one selected from the group consisting of plate-like graphite, graphene, graphene oxide, and graphite flake, and preferably may be plate-like graphite.

In the present application, the negative electrode conductive material may be a linear conductive material such as carbon nanotubes. The carbon nanotubes may be bundle-type carbon nanotubes. The bundle-type carbon nanotubes may include a plurality of carbon nanotube units. Specifically, the term 'bundle type' herein refers to, unless otherwise specified, a bundle or rope-shaped secondary shape in which a plurality of carbon nanotube units are aligned side by side in such an orientation that longitudinal axes of the carbon nanotube units are substantially the same, or are entangled. The carbon nanotube unit has a graphite sheet having a cylindrical shape with a nano-sized diameter, and has an sp2 bonding structure. In this case, the characteristics of a conductive material or a semiconductive material may be exhibited depending on the rolled angle and structure of the graphite sheet. As compared with entangled-type carbon nanotubes, the bundle-type carbon nanotubes can be more uniformly dispersed during the manufacture of the negative electrode, and can form more smoothly a conductive network in the negative electrode to improve the conductivity of the negative electrode.

In an exemplary embodiment of the present application, the negative electrode binder may include at least one selected from the group consisting of polyvinylidenefluoride-hexafluoropropylene copolymer (PVDF-co-HFP), polyvinylidenefluoride, polyacrylonitrile, polymethylmethacrylate, polyvinyl alcohol, carboxymethylcellulose (CMC), starch, hydroxypropylcellulose, regenerated cellulose, polyvinylpyrrolidone, tetrafluoroethylene, polyethylene, polypropylene, polyacrylic acid, ethylene-propylene-diene monomer (EPDM), sulfonated EPDM, styrene butadiene rubber (SBR), fluoro rubber, poly acrylic acid, and the above-described materials in which a hydrogen is substituted with Li, Na, Ca, etc., and may also include various copolymers thereof.

The negative electrode binder according to an exemplary embodiment of the present application serves to hold the active material and the conductive material in order to prevent distortion and structural deformation of the negative electrode structure during volume expansion and relaxation of the silicon-based active material. When such roles are satisfied, all of the general binders can be applied. Specifically, an aqueous binder may be used, and more specifically, a PAM-based binder may be used.

Accurately determining the point at which lithium plating occurs (precipitation point) is essential for ensuring the cycle durability of a cell. When deriving the state of charge using a three-electrode method of the related art, there is a problem in that the ohmic resistance caused by changes in f/p of the actual cell cannot be reflected. Since changes in the ohmic resistance of the cell due to f/p and the like also significantly affect charging performance, deriving the state of charge using the cell itself is a highly important technology.

In the case of a negative electrode active material using a carbon-based material, as Li is intercalated into the negative electrode, the potential decreases to a level similar to that of Li, and as the resistance or current increases, Li may accumulate on the surface without intercalation into the graphite layer, resulting in plating. Therefore, a safe charging protocol is established in such a way that the state of charge at which lithium plating occurs on the negative electrode is determined as the limit state of charge.

That is, in the case of a negative electrode using only a carbon-based material, the inflection section where the resistance decreases tends to be easily identified, making it relatively easy to set the state of charge.

Recently, the use of silicon-based active materials as negative electrode active materials has become essential for achieving high capacity, high energy density, and rapid charging. However, as the content of the silicon-based active material increases, it becomes more difficult to identify the inflection section of the resistance. In addition, due to the need for rapid charging, the C-rate during charging has been increasing, and as the C-rate increases, it also becomes more difficult to identify the inflection section of the resistance. For example, as the content of the silicon-based active material increases, it becomes difficult to identify the inflection section when the R(diff) value is small.

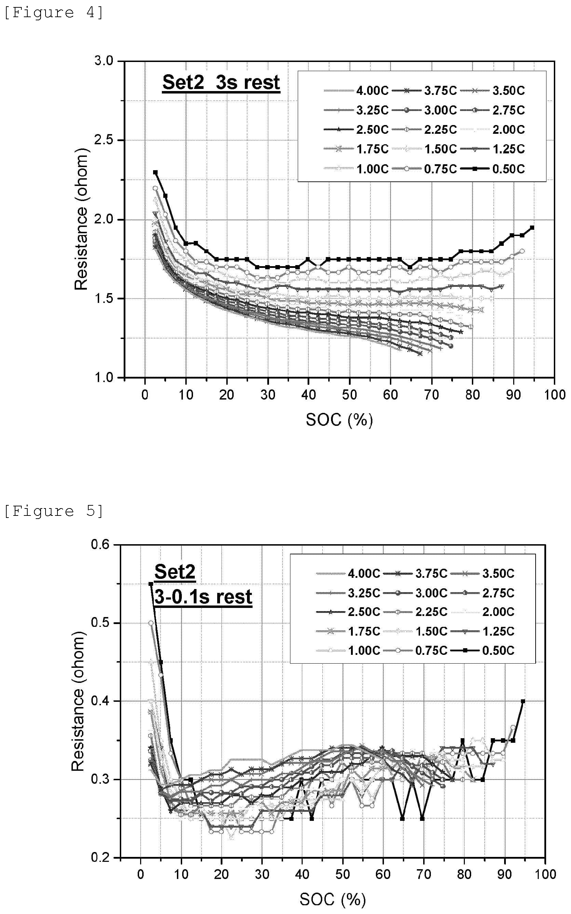

Specifically, FIG. 4 shows an analysis method for identifying an inflection section of resistance according to an approach of the related art, based on an increase in SOC by varying the C-rate for a negative electrode using a silicon-based active material (SiC 15%). As can be seen from FIG. 4, in a negative electrode using a silicon-based active material, it can be confirmed that an inflection section of resistance is not identified from the resistance measurement results at different C-rates, making it difficult to derive the state of charge.

This problem occurs in silicon-based active materials (such as SiO and SiC), as compared to carbon-based active materials, and is considered to be due to differences in the phase change mechanism during charging and the associated resistance change. For example, carbon-based active materials undergo intercalation reactions during charging, experience little structural change, and exhibit reversibility, resulting in low charge transfer resistance. In contrast, silicon-based active materials undergo alloying reactions and experience structural changes due to volume expansion, resulting in high charge transfer resistance and diffusion resistance even during normal behavior. Therefore, carbon-based active materials, which exhibit smaller resistance changes during normal behavior, allow easier detection of resistance changes when lithium plating occurs, as compared to silicon-based active materials.

Similarly, as the C-rate increases, the charge transfer resistance and diffusion resistance increase, making it difficult to detect changes in charge transfer and diffusion resistance due to precipitation at the relaxation time.

As $Li^+$ is intercalated into a negative electrode active material or forms an alloy (i.e., as SOC increases), the resistance value increases, and when $Li^+$ is plated, a parallel resistance is generated, thereby causing the resistance value to decrease. Based on this, the present application introduces a method of determining the state of charge at which lithium plating occurs in the negative electrode as the limit state of charge. That is, as shown in Equation 1 according to the present application, when the $R_{rest0.1s}$ value (IR drop) is subtracted from the $R_{rest3s}$ value, an inflection section of resistance can be easily identified. Specifically, in normal behavior, the resistance value increases as charging progresses. However, when lithium plating occurs as SOC increases, a parallel resistance is formed in addition to lithium insertion, causing the resistance value to decrease. By plotting the resistance values, the section in which the resistance increases and then decreases can be identified and determined as the limit state of charge.

In general, when comparing the behavior when lithium plating occurs and the behavior when lithium plating does not occur, the voltage drops immediately when lithium plating does not occur, whereas when lithium plating occurs, the voltage drops slowly as plated lithium is additionally inserted.

Here, "3s" refers to the section in which the voltage change with respect to time is the greatest. Although the definition may vary slightly due to differences in resistance components from cell to cell, the case in which the dV/dt value drops sharply, when the behavior during the relaxation time is plotted in the situation where lithium plating occurs, can be theoretically generalized to "3s" (3 seconds). That is, in this application, '3s' is defined as 3 seconds, which is determined as the time near the point where the dV/dt values, by which a pattern that well represents the QC cycle durability in the evaluation results is derived, drop sharply.

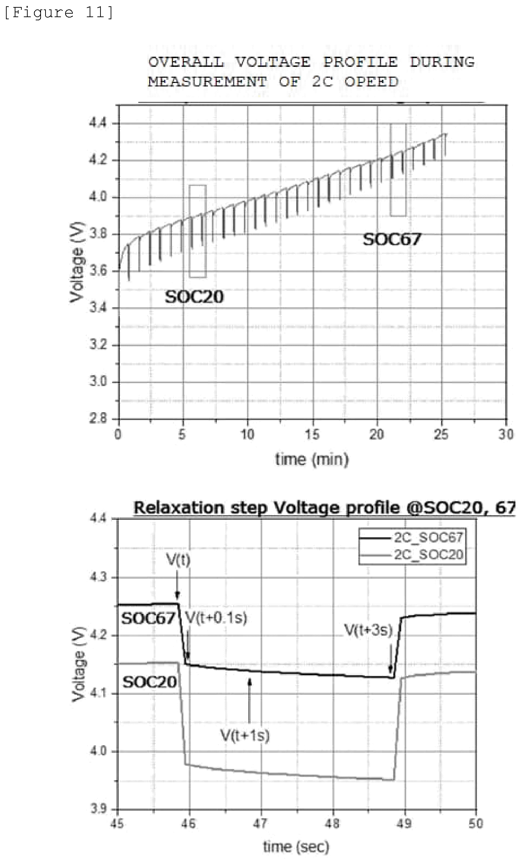

In addition, in the present application, the 0.1 seconds in $R_{rest0.1s}$ (IR drop) is defined as the time for subtracting only the ohmic resistance at which the IR drop is the largest. Specifically, if the IR drop occurs within a shorter time, that time may also be used, and the 0.1 seconds is used to define the largest IR drop ratio for 0.1 seconds within 3 seconds. FIG. 11 is a diagram for explaining the above, and specifically shows the voltage behavior at 2C. When looking at the resting voltage behaviors of SOC 67, which is the precipitation point, and SOC 20, which is not, both cases show a severe IR drop, indicating that the ratio of 0.1s within 3s is significantly large.

Specifically, FIG. 5 shows an analysis method for identifying an inflection section of resistance according to an approach of the present application in which a charging protocol of the present application is introduced, based on an increase in SOC by varying the C-rate for a battery including the same negative electrode as the negative electrode in FIG. 4. As can be seen in FIG. 5, while Li+ is intercalated into graphite or forms an alloy with SiO, SiC, or the like (as SOC increases), R(diff) increases, and when Li+ is plated, a parallel resistance is formed and R(diff) decreases. Therefore, this point can be determined as the precipitation point.

That is, as can be seen in FIG. 4, in cases where R(diff) is small, such as when there is an excess of silicon-based active materials such as SiC, the ratio of R(0.1s) to the entire R(3s) is large, making it difficult to distinguish the inflection point. In this case, as shown in FIG. 5, when only $R_{rest3-0.1s}$ ($R_{diff}$), which is obtained by subtracting the IR drop (R 0.1s) from the overall resistance (R 3s) change, is separated and observed, the inflection section becomes clearly distinguished. This is because, as described above, while $Li^+$ is intercalated into graphite or forms an alloy with SiO, SiC, or the like (as SOC increases), $R_{rest\ 3-0.1s}$ ($R_{diff}$) increases, and when $Li^+$ is plated, a parallel resistance is formed and $R_{rest\ 3-0.1s}$ ($R_{diff}$) decreases, making it possible to determine this point as the precipitation point. That is, it can be seen that, by plotting R(diff) and R(rest 3-0.1s) in FIG. 5, the section where the resistance increases and then decreases can be identified as the precipitation point.

When establishing a rapid charging protocol, the present invention derives a lithium-plating point, which serves as a reference for setting a limit state of charge, from an internal resistance profile obtained by plotting internal resistance values with respect to the state of charge of a battery cell.

Referring to FIG. 1, the battery management system 100 according to the present invention may include a measurement unit 110, a memory unit 120, and a control unit 130.

In the exemplary embodiment of FIG. 2, the battery management system 100 according to the present invention may further include a connection unit 140 configured to be connected to a charging device 200 capable of supplying charging current to the battery cell, in accordance with the charging protocol established by the control unit 130.

The charging device 200 may be connected to the battery pack 1. The charging device 200 connected to the battery pack 1 may supply charging current according to the charging protocol established by the control unit 130 for the battery cell 10.

The battery management system 100 may control an operation of a switching unit SW in order to control charging and discharging of the battery cell 10 or/and the battery module.

The measurement unit 110 is configured to measure state information on a battery cell, which includes at least one of a voltage and a state of charge of the battery cell 10. The measurement unit 110 according to the exemplary embodiment of the present invention is configured to measure a closed circuit voltage ($CCV_{SOCy}$) with respect to a state of charge ($SOCy$) and an open circuit voltage ($OCV_{SOCy}$) with respect to a state of charge ($SOCy$) for calculating an internal resistance value of the battery cell 10. The values of the closed circuit voltage ($CCV_{SOCy}$) and open circuit voltage ($OCV_{SOCy}$) measured by the measurement unit 110 become basis data for calculating the internal resistance value at the corresponding state of charge ($SOCy$).

The measurement unit 110 is configured to measure the closed circuit voltage ($CCV_{SOCy}$) and the open circuit voltage ($OCV_{SOCy}$) with respect to the state of charge at different charging currents ($I$), for the battery cell 10. In exemplary embodiments, the charging current ($I$) may be selected in plurality within a range of 0.1 C to 8.0 C, specifically 0.33C to 7.0 C, and more specifically 0.5 C to 5.0 C. In addition, an interval of the charging current ($I$) may be set to an interval of 0.1C to 1.0C. For example, for the battery cell 10, charging is performed up to SOC 100% with charging currents ($I$) of various values set at intervals of 0.25C, such as 0.25C - 0.5C - 0.75C... - 2.75C - 3.0C, and the measurement unit 110 is configured to measure the closed circuit voltage ($CCV_{SOCy}$) and the open circuit voltage ($OCV_{SOCy}$) with respect to the state of charge ($SOCy$) at each charging current ($I$), wherein each measurement point of the closed circuit voltage ($CCV_{SOCy}$) and the open circuit voltage ($OCV_{SOCy}$) may be set at an interval of SOC 2.5%, at an interval of SOC 5% interval, or at an interval of SOC 10%.

The memory unit 120 may collect and store an internal resistance profile obtained by calculating an internal compensated resistance value ($R_{rest3-0.1s}$) with respect to the state of charge by substituting the closed circuit voltage ($CCV_{SOCy}$) and open circuit voltage ($OCV_{SOCy}$) measured by the measurement unit 110 into Equation 1 below, and by plotting the internal compensated resistance value ($R_{rest3-0.1s}$) with respect to the state of charge for each charging current ($I$).

[Equation 1]

$$R_{rest\,3-0.1s}\,(R_{diff}) = R_{rest\,3s}\,(R_{total}) - R_{rest\,0.1s}\,(R_{ohmic})$$

Equation 1 represents resistance values respectively calculated when charging is performed in a pattern in which the battery cell is charged at a C-rate of x at 25°C based on SOC y% of capacity, followed by a rest period of 3 seconds (OCVSOCy) after charging to SOC y% (CCVSOCy),

the x is 0.1C or more and 8.0C or less,
the y is 0 or more and 100 or less,
the $R_{rest\,3s}$ is a resistance value after a rest period of 3 seconds (OCVSOCy) after charging to SOC y% (CCVSOCy), and
the $R_{rest\,0.1s}$ is a resistance value after a rest period of 0.1 seconds (OCVSOCy) after charging to SOC y% (CCVSOCy).

Since the difference between the closed circuit voltage and the open circuit voltage is caused by the voltage drop across the internal resistance, the actual internal resistance value of the battery cell may be calculated by dividing the difference between the closed circuit voltage and the open circuit voltage by the (rapid) charging current.

In this case, the open circuit voltage ($OCV_{SOCy}$) may be measured within 1 second to 30 seconds, within 1 second to 15 seconds, within 1 second to 10 seconds, or within 2 seconds to 9 seconds, from the time of measurement of the closed circuit voltage ($CCV_{SOCy}$).

In the present application, there is provided the battery management system in which the memory unit collects and stores an internal resistance profile obtained by plotting internal compensated resistance values ($R_{rest\ 3-0.1s}$) with respect to the state of charge at intervals of the y value of 1 to 2.5.

That is, the memory unit refers to a system that creates, collects, and stores a profile by continuously plotting internal compensated resistance values ($R_{rest\ 3-0.1s}$) with respect to the state of charge, at intervals of 1 to 2.5 for y values from 0 to 100 based on SOC.

The control unit 130 is configured to determine, from the internal resistance profile stored in the memory unit for each charging current (I), a limit state of charge corresponding to each charging current, and to establish a charging protocol based thereon.

The control unit 130 of the present invention may be configured to determine, as the limit state of charge, a value of the state of charge ($SOC_y$) at a point in the internal resistance profile where the shape of the graph changes from flat to a downward trend.

That is, the control unit of the present invention may be configured to calculate the Rdiff(y) value represented by Equation 1 above, and to determine, as the limit state of charge, a y value that satisfies $|Rdiff(y)-Rdiff(y+2.5)| \geq 0.1$ and is equal to or greater than 5.

Specifically, measurement is started from SOC 0 (y = 0) in a fully discharged state, and a graph is formed by measuring resistance while charging in increments of SOC 2.5. The measurement is repeated at SOC 2.5, 5, 7.5, and the like, and is terminated upon reaching the end voltage. In this case, the control unit may derive, as the state of charge, a y value that satisfies $IRdiff(y)-Rdiff(y+2.5)| \geq 1$ in a state where the y value is 5 or greater.

FIG. 5 shows an internal resistance profile with respect to the state of charge, derived by measuring a closed circuit voltage ($CCV_{SOCy}$) with respect to the state of charge (SOCy) and an open circuit voltage ($OCV_{SOCy}$) with respect to the state of charge (SOCy), respectively, at each charging current (I), calculating an internal resistance value ($R_{SOCy}$), and plotting the internal resistance value ($R_{SOCy}$) with respect to the state of charge (SOCy), according to an exemplary embodiment of the present invention.

Referring to FIG. 5, internal resistance profiles with respect to the state of charge are shown for various values of charging current set at intervals of 0.25 C, in the range of charging current (I) from 0.5 C to 4.0 C.

Looking at these profiles, a point can be identified where the shape of the internal resistance profile with respect to the state of charge changes from flat to a sharp drop. That is, in almost the entire range of charging current (from 0.5C to 4C), it can be observed that the resistance value remains constant at approximately 0.3 to 0.4, and then changes to a decreasing trend. The point at which a rapid decrease in the resistance value begins can be regarded as the point where lithium plating occurs.

When lithium plating occurs, lithium ions are intercalated into the graphite layer of the negative electrode and simultaneously bind to the plated lithium portion during the charging rest period. That is, in the state of charge region before the lithium plating occurs, lithium ions are intercalated into the negative electrode and are present as a series resistance, However, in the state of charge region after the lithium plating occurs, lithium ions are intercalated into the negative electrode and also undergo lithium plating, forming a parallel resistance, thereby causing the overall resistance to decrease. Therefore, in the internal resistance profile with respect to the state of charge, a decrease in the internal resistance value serves as an indicator that lithium plating has occurred.

Accordingly, the control unit 130 of the present invention determines, as the limit state of charge, a value of the state of charge ($SOC_y$) at the point where the graph of the internal resistance profile with respect to the state of charge changes from flat to a downward trend. After determining the limit state of charge corresponding to each charging current (I) as described above, the control unit 130 can establish a charging protocol based thereon.

The battery management system 100 according to the present invention has the effect of allowing the measurement unit 110, the memory unit 120, and the control unit 130 to charge the battery cell in accordance with a charging protocol that reflects the resistance of the large-capacity battery cell 10 and the heat generation during rapid charging.

In the present application, the battery management system is provided in which the control unit is configured to re-establish the charging protocol by periodically, during repeated charging and discharging of the battery cell, deriving a new limit state of charge corresponding to each charging current.

The control unit 130 may be configured to re-establish the charging protocol by periodically, during repeated charging and discharging of the battery cell, deriving a new limit state of charge corresponding to each charging current. This is to reflect the deterioration of the battery cell due to repeated charging and discharging.

For example, the control unit 130 controls the measurement unit 110 to measure a closed circuit voltage ($CCV_{SOCy}$) with respect to a state of charge ($SOC_y$) and an open circuit voltage ($OCV_{SOCy}$) with respect to a state of charge(SOCy), respectively, during charging with each of different charging currents (I), for a battery cell, for every 100 cycles, controls the memory unit 120 to collect and store an internal resistance profile obtained by calculating an internal resistance value ($R_{SOCy}$) with respect to the state of charge by substituting the measured closed circuit voltage ($CCV_{SOCy}$) and open circuit voltage ($OCV_{SOCy}$)into Equation 1 below, and by plotting the internal resistance value with respect to the state of charge for each charging current (I), derives a new limit state of charge corresponding to each charging current from the internal resistance profile stored in the memory unit, and based thereon, establishes a new charging protocol reflecting deterioration.

Accordingly, the battery management system according to the present invention has the effect of non-destructively identifying the degree of deterioration of a battery cell even during operation of the battery cell, and updating the charging protocol by reflecting the deterioration of the battery cell.

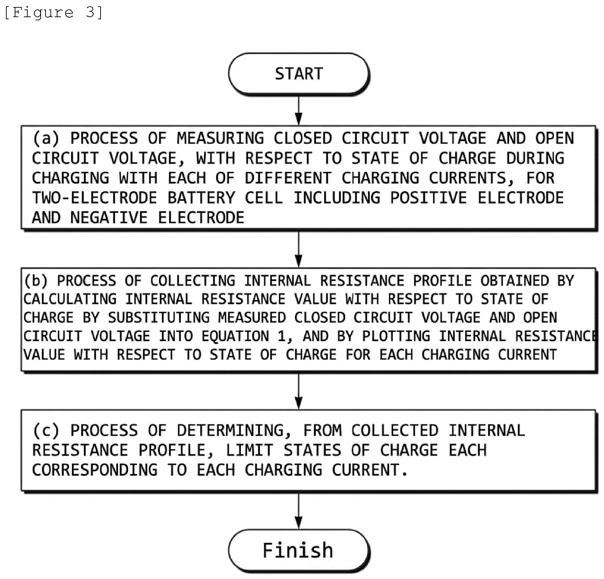

FIG. 3 is a flowchart of a method for establishing a charging protocol for a lithium secondary battery according to an exemplary embodiment of the present invention.

Referring to FIG. 3, a method for establishing a charging protocol according to an exemplary embodiment of the present invention includes the processes of:

(a) measuring a closed circuit voltage ($CCV_{SOCy}$) and an open circuit voltage ($OCV_{SOCy}$), with respect to a state of charge ($SOCy$), during charging with each of different charging currents (I), for a two-electrode battery cell including a positive electrode and a negative electrode;

(b) collecting an internal resistance profile obtained by calculating an internal compensated resistance value ($R_{rest3-0.1s}$) with respect to the state of charge by substituting the measured closed circuit voltage ($CCV_{SOCy}$) and open circuit voltage ($OCV_{SOCy}$) into Equation 1 below, and by plotting the internal compensated resistance value ($R_{rest3-0.1s}$) with respect to the state of charge for each charging current (I); and

(c) determining, from the collected internal resistance profile, limit states of charge each corresponding to each charging current.

[Equation 1]

$$R_{rest\ 3-0.1s}\ (R_{diff}) = R_{rest\ 3s}\ (R_{total}) - R_{rest\ 0.1s}\ (R_{ohmic})$$

Equation 1 represents resistance values respectively calculated when charging is performed in a pattern in which the battery cell is charged at a C-rate of x at 25°C based on SOC y% of capacity, followed by a rest period of 3 seconds ($OCVSOCy$) after charging to SOC y% ($CCVSOCy$),

the x is 0.1C or more and 8.0C or less,
the y is 0 or more and 100 or less,
the $R_{rest\ 3s}$ is a resistance value after a rest period of 3 seconds ($OCVSOCy$) after charging to SOC y% ($CCVSOCy$), and
the $R_{rest\ 0.1s}$ is a resistance value after a rest period of 0.1 seconds ($OCVSOCy$) after charging to SOC y% ($CCVSOCy$).

In establishing a charging protocol according to the present invention, the limit state of charge may be a value of the state of charge ($SOC_y$) at a point where the graph of the internal resistance profile with respect to the state of charge changes from flat to a downward trend.

In the method of establishing a charging protocol according to the related art, a three-electrode cell with a capacity at a level of 50 mAh has been fabricated in advance for deriving a limit state of charge, and the lithium plating point with respect to the negative electrode potential has been derived as the limit state of charge. However, according to the present invention, fabrication of a three-electrode cell is not required, and the limit state of charge can be derived directly through the calculation of the internal resistance value for a large-capacity two-electrode battery cell with a capacity of 40 to 200 Ah.

The method for establishing a charging protocol according to exemplary embodiments may further include a process of mapping a charging protocol based on a limit state of charge for each charging current. The mapping process may be such that, for each charging current, charging is mapped to be performed with a corresponding charging current up to a limit state of charge, with the charging current decreasing as the state of charge increases.

The mapping process may be such that, for each charging current, charging is mapped to be performed with a corresponding charging current up to a limit state of charge, with the charging current decreasing as the state of charge increases. For example, if the limit state of charge corresponding to a charging current of 3.0C is SOC 40%, the limit state of charge corresponding to a charging current of 2.5C is SOC 45%, the limit state of charge corresponding to a charging current of 2.0C is SOC 55%, and the limit state of charge corresponding to a charging current of 1.5C is SOC 65%, charging may be mapped to be performed with a charging current of 3.0C up to SOC 40%, 2.5C up to SOC 45%, 2.0C up to SOC 55%, and 1.5C up to SOC 65%.

[Best Mode]

Hereinafter, a battery management system and a method for establishing a charging protocol of the present invention, which derive a limit state of charge corresponding to a charging current and establish a charging protocol according to the present invention, will be described in detail with specific examples.

## Preparation Example 1

### (1) Preparation of Positive Electrode

A positive electrode slurry was prepared by adding a positive electrode active material ($Li(Ni_aCo_bMn_c)O_2$ in which NCM excluding lithium (Li) and oxygen ($O_2$) has a ratio of Ni:Co:Mn=60/10/30 and satisfies the ratio (a:b:c=0.60:0.10:0.30)), a positive electrode conductive material (LB.CNT) and a binder (PVdF, KF9700) to a solvent (N-methylpyrrolidone, NMP) in a weight ratio of 97.0:1.56:1.44. The positive electrode slurry was applied to a 12 $\mu$m-thick aluminum (Al) thin film, which was a positive electrode current collector, dried, and then roll-pressed to prepare a positive electrode.

### (2) Preparation of Negative Electrode

As a negative electrode active material, artificial graphite, natural graphite, and Si/C (average particle size (D50): 9.5 $\mu$m) were prepared in a ratio of 68:17:15.
Then, the negative electrode active material, SWCNT (single wall-CNT, specific surface area 1160 $m^2$/g), and polyacrylamide as a binder were prepared in a weight ratio of 96:0.05:3.95 to prepare a negative electrode active material layer composition. A negative electrode slurry (solid concentration: 46 wt%) was prepared by adding the composition to distilled water as a solvent for formation of a negative electrode slurry.
As a mixing method, water and a dispersant were dispersed using a homo mixer at 1500 rpm for 10 minutes. After that, the negative electrode active material was added and dispersed using a planetary mixer at 45 rpm for 30 minutes. Then, SWCNTs were added and dispersed using a homo mixer at 500 rpm for 45 minutes. Finally, a binder and viscosity control agent were added and mixed to prepare a negative electrode slurry.
The negative electrode slurry was coated on both surfaces of a copper current collector (thickness: 6 $\mu$m) serving as a negative electrode current collector with a loading amount of 7.00 mg/$cm^2$, which was then roll-pressed and dried for 10 hours to form a negative electrode active material layer (thickness: 80 $\mu$m).

### (3) Preparation of Secondary Battery

An electrode assembly was prepared by interposing a compression-resistant thin film separator (PE 9 $\mu$m) with a ceramic coating of 3 $\mu$m/3 $\mu$m between the positive electrode and the negative electrode. After placing the electrode assembly inside a case, an electrolyte was injected into the case to prepare a lithium secondary battery.

## Preparation Example 2

A secondary battery was prepared in the same manner as in Preparation Example 1, except that, in Preparation Example 2, artificial graphite and natural graphite were prepared in a ratio of 80:20 as a negative electrode active material during the preparation of the negative electrode, and a point-like conductive material (D50:40 $\mu$m, specific surface area: 65 $m^2$/g) was used instead of SWCNT.

## Comparative Example 1

For the battery cell of Preparation Example 1 with SOC 2.5%, charging was performed with a charging current of 0.5C, and the measurement unit measured the closed circuit voltage ($CCV_{SOCy}$) and open circuit voltage ($OCV_{SOCy}$) of the battery cell at state-of-charge intervals of SOC 2.5%. The measured values were then substituted into the following equation to calculate the internal resistance value at the corresponding state of charge.

Internal resistance value with respect to state of charge ($R_{SOCy}$) = ($CCV_{SOCy}$ - $OCV_{SOCy}$)/I  [Equation]

Then, by plotting the corresponding relationship between the state of charge on the x-axis and the internal resistance value on the y-axis, the internal resistance profile with respect to the state of charge, as shown in FIG. 4, was obtained and stored in the memory unit.

Then, the same process was repeated for each charging current of 0.75C, 1.0C, 1.25C, 1.5C, 1.75C, 2.0C, 2.25C, 2.5C, 2.75C, 3.0C, 3.5C, 3.75C, and 4.00C, and the internal resistance profile with respect to each state of charge (SOCy) for each charging current was obtained and stored in the memory unit.

Then, the control unit determined, from the internal resistance profiles with respect to the state of charge of FIG. 4 stored in the memory unit, the charging degree at the point where the shape of the graph changes from flat to a downward trend, as the limit state of charge for each charging current. It can be confirmed that the point where the shape of the graph changes from flat to a downward trend is not clearly derived.

## Example 1

For the battery cell of Preparation Example 1 with SOC of 2.5%, while charging was performed at a C-rate of 0.5C at 25°C, the measurement unit calculated the resistance values when charging was performed in a pattern in which the battery cell was charged based on SOC 2.5% of capacity, followed by rest periods of 3 seconds (OCVSOCy) and 0.1 seconds (OCVSOCy) after charging to SOC 2.5% (CCVSOCy), and substituted the calculated resistance values into the following equation to calculate the internal resistance value at the corresponding state of charge.

[Equation]

$$R_{rest\ 3-0.1s}\ (R_{diff}) = R_{rest\ 3s}\ (R_{total}) - R_{rest\ 0.1s}\ (R_{ohmic})$$

The $R_{rest\ 3s}$ is a resistance value after a rest period of 3 seconds (OCVSOCy) after charging to SOC y% (CCVSOCy), and the $R_{rest\ 0.1s}$ is a resistance value after a rest period of 0.1 seconds (OCVSOCy) after charging to SOC y% (CCVSOCy).

Then, by plotting the corresponding relationship between the state of charge on the x-axis and the internal resistance value on the y-axis, the internal resistance profile with respect to the state of charge, as shown in FIG. 5, was obtained and stored in the memory unit.

Then, the same process was repeated for each charging current of 0.75C, 1.0C, 1.25C, 1.5C, 1.75C, 2.0C, 2.25C, 2.5C, 2.75C, 3.0C, 3.5C, 3.75C, and 4.00C, and the internal resistance profile with respect to each state of charge (SOCy) for each charging current was obtained and stored in the memory unit.

Then, the control unit determined, from the internal resistance profiles with respect to the state of charge of FIG. 5 stored in the memory unit, the charging degree at the point where the shape of the graph changes from flat to a downward trend, as the limit state of charge for each charging current, and established a charging protocol as shown in Table 1 as a result.

[Table 1]

| Charging current (C-rate) | 4.00 | 3.75 | 3.5 | 3.25 | 3.0 | 2.75 | 2.5 | 2.25 | 2.0 | 1.75 | 1.5 | 1.25 | 1.0 | 0.75 | 0.5 |
|---|---|---|---|---|---|---|---|---|---|---|---|---|---|---|---|
| State of charge (SOC) | 52 | 53 | 54.5 | 56 | 59 | 62 | 65 | 68 | 71 | 74.5 | 77.5 | 81 | 85 | 89.5 | 94 |

## Reference Example 2

For the battery cell of Preparation Example 2 with SOC 2.5%, charging was performed with a charging current of 0.5C, and the measurement unit measured the closed circuit voltage ($CCV_{SOCy}$) and open circuit voltage ($OCV_{SOCy}$) of the battery cell at state-of-charge intervals of SOC 2.5%. The measured values were then substituted into the following equation to calculate the internal resistance value at the corresponding state of charge.

Internal resistance value with respect to state of charge $(R_{SOCy})$ = $(CCV_{SOCy} - OCV_{SOCy})/I$                    [Equation]

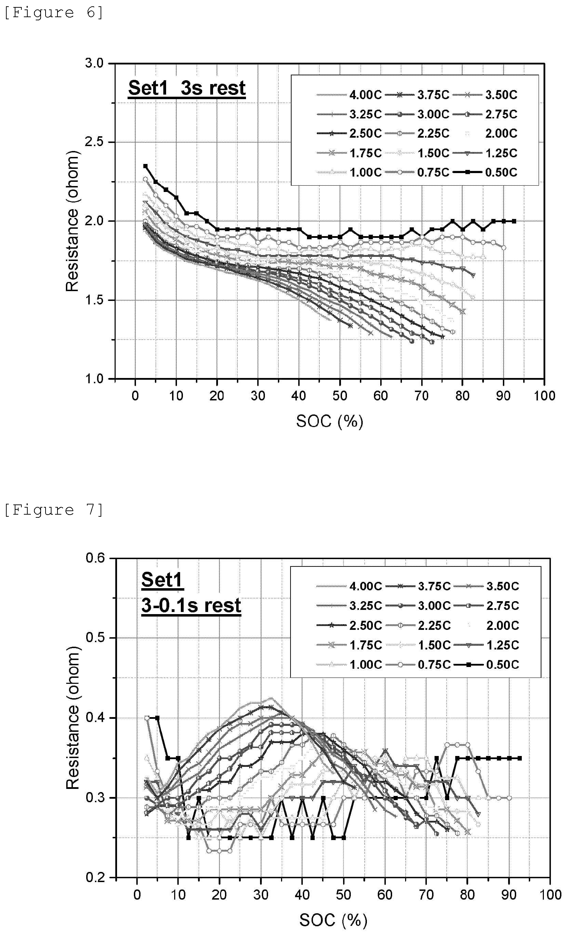

Then, by plotting the corresponding relationship of the state of charge on the x-axis and the internal resistance value on the y-axis, the internal resistance profile with respect to the state of charge, as shown in FIG. 6, was obtained and stored in the memory unit.

Then, the same process was repeated for each charging current of 0.75C, 1.0C, 1.25C, 1.5C, 1.75C, 2.0C, 2.25C, 2.5C, 2.75C, 3.0C, 3.5C, 3.75C, and 4.00C, and the internal resistance profile with respect to each state of charge (SOCy) for each charging current was obtained and stored in the memory unit.

Then, the control unit determined, from the internal resistance profiles with respect to the state of charge of FIG. 6 stored in the memory unit, the charging degree at the point where the shape of the graph changes from flat to a downward trend, as the limit state of charge for each charging current. It can be confirmed that the point where the shape of the graph changes from flat to a downward trend is not clearly derived.

## Example 2

For the battery cell of Preparation Example 2 with SOC of 2.5%, while charging was performed at a C-rate of 0.5C at 25°C, the measurement unit calculated the resistance values when charging was performed in a pattern in which the battery cell was charged based on SOC 2.5% of capacity, followed by rest periods of 3 seconds (OCVSOCy) and 0.1 seconds (OCVSOCy) after charging to SOC 2.5% (CCVSOCy), and substituted the calculated resistance values into the following equation to calculate the internal resistance value at the corresponding state of charge.

[Equation]

$$R_{rest\ 3-0.1s}\ (R_{diff})\ =\ R_{rest\ 3s}\ (R_{total})\ -\ R_{rest\ 0.1s}\ (R_{ohmic})$$

The $R_{rest\ 3s}$ is a resistance value after a rest period of 3 seconds (OCVSOCy) after charging to SOC y% (CCVSOCy), and the $R_{rest\ 0.1s}$ is a resistance value after a rest period of 0.1 seconds (OCVSOCy) after charging to SOC y% (CCVSOCy).

Then, by plotting the corresponding relationship between the state of charge on the x-axis and the internal resistance value on the y-axis, the internal resistance profile with respect to the state of charge, as shown in FIG. 7, was obtained and stored in the memory unit.

Then, the same process was repeated for each charging current of 0.75C, 1.0C, 1.25C, 1.5C, 1.75C, 2.0C, 2.25C, 2.5C, 2.75C, 3.0C, 3.5C, 3.75C, and 4.00C, and the internal resistance profile with respect to each state of charge (SOCy) for each charging current was obtained and stored in the memory unit.

Then, the control unit determined, from the internal resistance profiles with respect to the state of charge of FIG. 7 stored in the memory unit, the charging degree at the point where the shape of the graph changes from flat to a downward trend, as the limit state of charge for each charging current, and established a charging protocol as shown in Table 2 as a result.

[Table 2]

| Charging current (C-rate) | 4.00 | 3.7 5 | 3.5 | 3.2 5 | 3.0 | 2.7 5 | 2.5 | 2.2 5 | 2.0 | 1.7 5 | 1.5 | 1.2 5 | 1. 0 | 0.7 5 | 0.5 |
|---|---|---|---|---|---|---|---|---|---|---|---|---|---|---|---|
| State of charge (SOC) fresh | 31 | 32. 5 | 35 | 37. 5 | 40 | 42. 5 | 45 | 47. 5 | 50. 5 | 55 | 59. 5 | 64 | 70 | 80 | 92. 5 |
| State of charge (SOC) aged | 19.7 | 22. 2 | 24. 6 | 27. 1 | 29. 6 | 32 | 34. 5 | 37 | 40 | 44. 5 | 50. 5 | 56. 7 | 66 | 74 | 83. 8 |

Reference Example 2 relates to a negative electrode composed of 100% graphite (Gr), and although the resistance inflection section is relatively distinguishable even using R3s, a state of charge at 24.9 minutes was derived with reference to Rdiff (R3s-0.1s), which shows the change more clearly, as can be seen in FIG. 7. Comparative Example 1 is a cell containing 15% SiC, and as can be seen in FIG. 4, the resistance inflection section is not clearly distinguishable with $R_{rest\ 3s}$. Therefore, a state of charge at 13.9 minutes was derived using Rdiff (R3s-0.1s), as shown in FIG. 5.

That is, in Comparative Example 1 and Reference Example 2, it can be confirmed that it was difficult to derive the state of charge using the approach of the related art. In Examples 1 and 2, it can be confirmed that the state of charge can be derived according to the method of the present application.

**Experimental Example 1: Capacity retention rate evaluation**

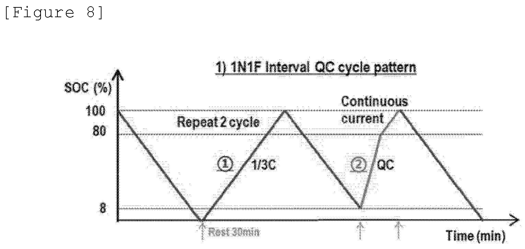

The QC cycle was conducted in the same manner as in FIG. 8, and specifically, the measurement was performed using the following manner.

1) Normal cycle (blue charge/discharge): CC-CV charging from SOC 0 to 100 at 1/3C, 4.35 V, with a 0.05C cut-off, followed by a 30-minute rest; CC discharging from SOC 100 to 8 at 1/3C with a cut-off at the SOC 8 voltage, followed by a 30-minute rest.

2) QC cycle (red charge / green charge / blue discharge): charging from SOC 8 to 80 using the derived state of charge; CC-CV charging from SOC 80 to 100 at 1/3C, 4.35 V, with a 0.05C cut-off, followed by a 30-minute rest; CC discharging from SOC 100 to 8 at 1/3C with a cut-off at the SOC 8 voltage, followed by a 30-minute rest.

After repeating the cycles of 1) and 2) twice, in FIG. 8, the left Y-axis indicates the retention of the charge amount in ① of the schematic diagram, and the right Y-axis indicates the voltage at the end of the final step of the quick charge in ② of the schematic diagram.

- . Capacity retention rate evaluation: The cycle was terminated after the voltage in ② reached 4.35 V (in this test, 600 cycles). The corresponding results are shown in Table 3 below.

Charging capacity in each cycle ①/Initial charge capacity * 100                               Formula 1:

[Table 3]

|  | Example 1 | Example 2 |
|---|---|---|
| Capa. Reten. (%) @600cycle | 94.1 | 92.6 |

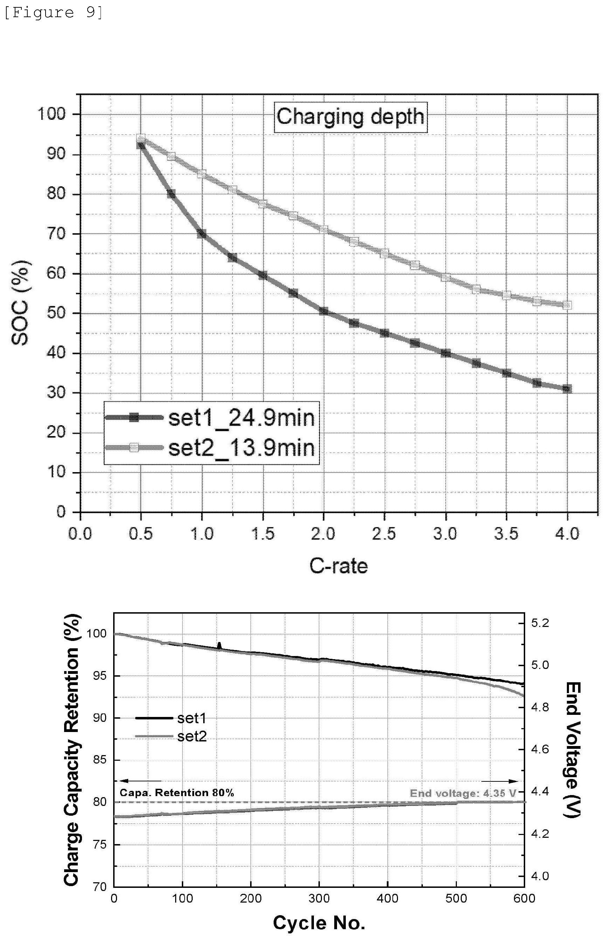

As can be seen in FIG. 9, it can be confirmed that the patterns of 24.9 minutes and 13.9 minutes derived from different chemistries, such as negative electrodes of Gr 100% (Example 2, Preparation Example 2, set 1) and SiC 15% (Example 1, Preparation Example 1, set 2) exhibit similar levels of QC cycle life. Both cells reached 4.35 V at the 500th cycle and showed equivalent cycle performance up to that point, indicating that the state-of-charge analysis method according to the present application is highly effective. The decrease in capacity after reaching the end voltage is considered to result from differences in degradation behavior due to the differences in chemistry. Ideally, the cell should be used until reaching the end voltage. The 1.5% difference in retention at the 600th cycle corresponds to a level that can be regarded as within the variation between cells.

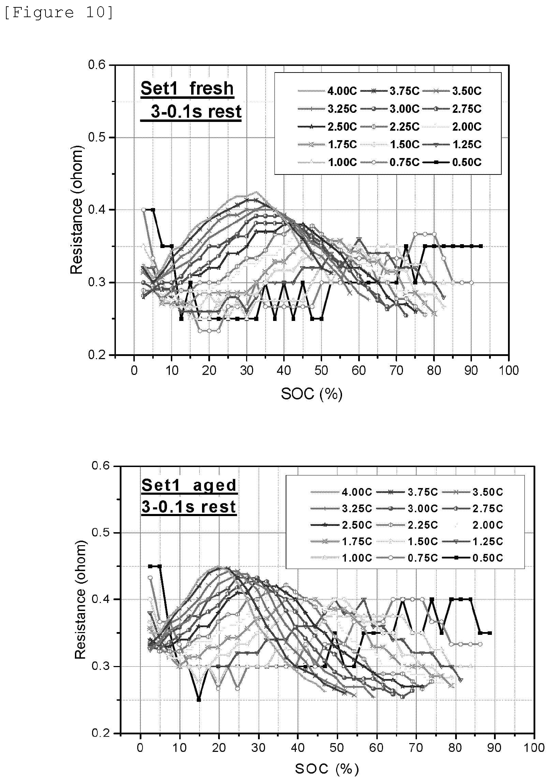

For reference, as can be seen in FIG. 10 and Table 2, when the range of Equation 1 ($R_{diff}$ ($R_{3-0.1s}$)) of the present invention is derived for the aged cell of Preparation Example 2 (Example 2), the absolute resistance value increased from 0.30 mOhm to 0.35 mOhm compared to the fresh cell, and the rate of increase varied depending on the charge rate. In addition, the plating zone, in which the resistance increases and then decreases, appeared to extend further toward the lower SOC range, indicating that the degree of deterioration varies depending on the charge rate. Therefore, it can be confirmed that the degree of deterioration can be identified through non-destructive testing during cycle operation, and that the rapid charging protocol can be modified by adjusting the state of charge.

**Claims**

1. A battery management system comprising:

a measurement unit configured to measure a closed circuit voltage ($CCV_{SOCy}$) and an open circuit voltage ($OCV_{SOCy}$), with respect to a state of charge (SOCy) during charging with each of different charging currents (I), for a two-electrode battery cell comprising a positive electrode and a negative electrode;

a memory unit configured to collect and store an internal resistance profile obtained by calculating an internal compensated resistance value ($R_{rest3-0.1s}$) with respect to the state of charge by substituting the measured closed circuit voltage ($CCV_{SOCy}$) and open circuit voltage ($OCV_{SOCy}$) into Equation 1, and by plotting the internal compensated resistance value ($R_{rest3-0.1s}$) with respect to the state of charge for each charging current (I); and

a control unit configured to determine, from the internal resistance profile, limit states of charge each corresponding to each charging current, and to establish a charging protocol based thereon,

[Equation 1]

$$R_{rest\,3-0.1s}\,(R_{diff}) = R_{rest\,3s}\,(R_{total}) - R_{rest\,0.1s}\,(R_{ohmic})$$

wherein Equation 1 represents resistance values respectively calculated when charging is performed in a pattern in which the battery cell is charged at a C-rate of x at 25°C based on SOC y% of capacity, followed by a rest period of 3 seconds (OCVSOCy) after charging to SOC y% (CCVSOCy),

the x is 0.1C or more and 8.0C or less,

the y is 0 or more and 100 or less,

the $R_{rest\,3s}$ is a resistance value after a rest period of 3 seconds (OCVSOCy) after charging to SOC y% (CCVSOCy), and

the $R_{rest\,0.1s}$ is a resistance value after a rest period of 0.1 seconds (OCVSOCy) after charging to SOC y% (CCVSOCy).

2. The battery management system of claim 1, wherein the memory unit collects and stores an internal resistance profile obtained by plotting internal compensated resistance values ($R_{rest3-0.1s}$) with respect to the state of charge at intervals of the y value of 1 to 2.5.

3. The battery management system of claim 1, wherein the control unit is configured to determine, as the limit state of charge, a value of the state of charge ($SOC_y$) at a point in the internal resistance profile where a shape of a graph changes from flat to a downward trend.

4. The battery management system of claim 1, wherein the control unit is configured to calculate the Rdiff(y) value represented by Equation 1, and to determine, as the limit state of charge, a y value that satisfies |Rdiff(y)-Rdiff(y+2.5)| ≥ 0.1 and is equal to or greater than 5.

5. The battery management system of claim 1, wherein the control unit is configured to re-establish the charging protocol by periodically, during repeated charging and discharging of the battery cell, deriving a new limit state of charge corresponding to each charging current.

6. The battery management system of claim 1, comprising a connection unit configured to be connected to a charging device for supplying charging current to the battery cell in accordance with the charging protocol established by the control unit.

7. The battery management system of claim 1, wherein the measurement unit is configured to measure state information on a battery cell, the state information comprising at least one of a voltage and a state of charge of the battery cell.

8. A battery pack comprising the battery management system of any one of claims 1 to 7.

9. The battery pack of claim 8, comprising a plurality of battery cells each having a capacity of 1 Ah to 200 Ah.

10. A method for establishing a charging protocol for a lithium secondary battery, the method comprising:

   (a) measuring a closed circuit voltage ($CCV_{SOCy}$) and an open circuit voltage ($OCV_{SOCy}$), with respect to a state of charge (SOCy) during charging with each of different charging currents (I), for a two-electrode battery cell comprising a positive electrode and a negative electrode;

(b) collecting an internal resistance profile obtained by calculating an internal compensated resistance value ($R_{rest3-0.1s}$) with respect to the state of charge by substituting the measured closed circuit voltage ($CCV_{SOCy}$) and open circuit voltage ($OCV_{SOCy}$) into Equation 1, and by plotting the internal compensated resistance value ($R_{rest3-0.1s}$) with respect to the state of charge for each charging current (I); and
(c) determining, from the collected internal resistance profile, limit states of charge each corresponding to each charging current,

[Equation 1]

$$R_{rest\ 3-0.1s}\ (R_{diff}) = R_{rest\ 3s}\ (R_{total}) - R_{rest\ 0.1s}\ (R_{ohmic})$$

wherein Equation 1 represents resistance values respectively calculated when charging is performed in a pattern in which the battery cell is charged at a C-rate of x at 25°C based on SOC y% of capacity, followed by a rest period of 3 seconds (OCVSOCy) after charging to SOC y% (CCVSOCy),
the x is 0.1C or more and 8.0C or less,
the y is 0 or more and 100 or less,
the $R_{rest\ 3s}$ is a resistance value after a rest period of 3 seconds (OCVSOCy) after charging to SOC y% (CCVSOCy), and
the $R_{rest\ 0.1s}$ is a resistance value after a rest period of 0.1 seconds (OCVSOCy) after charging to SOC y% (CCVSOCy).

11. The method of claim 10, wherein in the (c), the limit state of charge is determined as a value of the state of charge ($SOC_y$) at a point in the internal resistance profile where a shape of a graph changes from flat to a downward trend.

12. The method of claim 10, wherein in the (c), the limit state of charge is determined by calculating a Rdiff(y) value represented by Equation 1 above, and deriving, as a limit state of charge, a y value that satisfies |Rdiff(y)-Rdiff(y+2.5)| ≥ 0.1 and is equal to or greater than 5.

13. The method of claim 10, wherein the two-electrode cell has a capacity of 1 Ah to 200 Ah.

14. The method of claim 10, further comprising mapping a charging protocol based on a limit state of charge for each charging current, wherein
the mapping is such that, for each charging current, charging is mapped to be performed with a corresponding charging current up to a limit state of charge, with the charging current decreasing as the state of charge increases.

[Figure 1]

[Figure 2]

[Figure 3]

```
                              ┌─────────────┐
                              │    START    │
                              └──────┬──────┘
                                     │
                                     ▼
┌────────────────────────────────────────────────────────────────────┐
│ (a) PROCESS OF MEASURING CLOSED CIRCUIT VOLTAGE AND OPEN             │
│ CIRCUIT VOLTAGE, WITH RESPECT TO STATE OF CHARGE DURING             │
│ CHARGING WITH EACH OF DIFFERENT CHARGING CURRENTS, FOR              │
│ TWO-ELECTRODE BATTERY CELL INCLUDING POSITIVE ELECTRODE             │
│ AND NEGATIVE ELECTRODE                                              │
└────────────────────────────────────┬───────────────────────────────┘
                                     │
                                     ▼
┌────────────────────────────────────────────────────────────────────┐
│ (b) PROCESS OF COLLECTING INTERNAL RESISTANCE PROFILE OBTAINED BY    │
│ CALCULATING INTERNAL RESISTANCE VALUE WITH RESPECT TO STATE OF      │
│ CHARGE BY SUBSTITUTING MEASURED CLOSED CIRCUIT VOLTAGE AND OPEN     │
│ CIRCUIT VOLTAGE INTO EQUATION 1, AND BY PLOTTING INTERNAL RESISTANCE│
│ VALUE WITH RESPECT TO STATE OF CHARGE FOR EACH CHARGING CURRENT     │
└────────────────────────────────────┬───────────────────────────────┘
                                     │
                                     ▼
┌────────────────────────────────────────────────────────────────────┐
│ (c) PROCESS OF DETERMINING, FROM COLLECTED INTERNAL                  │
│ RESISTANCE PROFILE, LIMIT STATES OF CHARGE EACH                     │
│ CORRESPONDING TO EACH CHARGING CURRENT.                             │
└────────────────────────────────────┬───────────────────────────────┘
                                     │
                                     ▼
                              ┌─────────────┐
                              │   Finish    │
                              └─────────────┘
```

[Figure 4]

[Figure 5]

[Figure 6]

[Figure 7]

[Figure 8]

[Figure 9]

[Figure 10]

[Figure 11]

OVERALL VOLTAGE PROFILE DURING
MEASUREMENT OF 2C OPEED

Relaxation step Voltage profile @SOC20, 67

# EP 4 773 463 A1

## INTERNATIONAL SEARCH REPORT

International application No.

**PCT/KR2025/005165**

### A. CLASSIFICATION OF SUBJECT MATTER

**H02J 7/00**(2006.01)i; **G01R 31/3835**(2019.01)i; **G01R 31/389**(2019.01)i; **H01M 10/44**(2006.01)i

According to International Patent Classification (IPC) or to both national classification and IPC

### B. FIELDS SEARCHED

Minimum documentation searched (classification system followed by classification symbols)

H02J 7/00(2006.01); B60L 58/10(2019.01); G01R 31/36(2006.01); G01R 31/3835(2019.01); G01R 31/389(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 충전 프로토콜(charging protocol), 충전 심도(depth of charge), 저항(resistance), 플로팅(plotting)

### C. DOCUMENTS CONSIDERED TO BE RELEVANT

| Category* | Citation of document, with indication, where appropriate, of the relevant passages | Relevant to claim No. |
|---|---|---|
| A | KR 10-2024-0067042 A (LG ENERGY SOLUTION, LTD.) 16 May 2024 (2024-05-16) <br> see paragraphs [0079]-[0089]; claim 1; and figure 6. | 1-14 |
| A | JP 2022-086261 A (FURUKAWA BATTERY CO., LTD.) 09 June 2022 (2022-06-09) <br> see paragraphs [0030]-[0038]; and figures 1-4. | 1-14 |
| A | KR 10-2024-0067039 A (LG ENERGY SOLUTION, LTD.) 16 May 2024 (2024-05-16) <br> see paragraphs [0055]-[0088]; and figure 1. | 1-14 |
| A | JP 2014-149280 A (TOSHIBA CORP.) 21 August 2014 (2014-08-21) <br> see paragraphs [0030]-[0051]; and figure 2. | 1-14 |
| A | US 2008-0122399 A1 (HAJIME NISHINO et al.) 29 May 2008 (2008-05-29) <br> see paragraphs [0029]-[0045]; and figures 1-3. | 1-14 |

☐ Further documents are listed in the continuation of Box C.  ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **04 August 2025** | **04 August 2025** |

| Name and mailing address of the ISA/KR | Authorized officer |
|---|---|
| **Korean Intellectual Property Office** <br> **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2025/005165**

| Patent document cited in search report | | | Publication date (day/month/year) | Patent family member(s) | | | Publication date (day/month/year) |
|---|---|---|---|---|---|---|---|
| KR | 10-2024-0067042 | A | 16 May 2024 | CN | 119096448 | A | 06 December 2024 |
| | | | | EP | 4507159 | A2 | 12 February 2025 |
| | | | | JP | 2025-517137 | A | 03 June 2025 |
| | | | | KR | 10-2676183 | B1 | 19 June 2024 |
| | | | | WO | 2024-101901 | A2 | 16 May 2024 |
| | | | | WO | 2024-101901 | A3 | 04 July 2024 |
| JP | 2022-086261 | A | 09 June 2022 | JP | 7500404 | B2 | 17 June 2024 |
| KR | 10-2024-0067039 | A | 16 May 2024 | CN | 118661358 | A | 17 September 2024 |
| | | | | EP | 4468557 | A1 | 27 November 2024 |
| | | | | EP | 4468557 | A4 | 11 June 2025 |
| | | | | JP | 2025-507591 | A | 21 March 2025 |
| | | | | KR | 10-2676209 | B1 | 19 June 2024 |
| | | | | US | 12334769 | B2 | 17 June 2025 |
| | | | | US | 2025-0112485 | A1 | 03 April 2025 |
| | | | | WO | 2024-101897 | A1 | 16 May 2024 |
| JP | 2014-149280 | A | 21 August 2014 | EP | 2762908 | A1 | 06 August 2014 |
| | | | | EP | 2762908 | B1 | 19 August 2015 |
| | | | | JP | 6239241 | B2 | 29 November 2017 |
| | | | | US | 2014-0222358 | A1 | 07 August 2014 |
| US | 2008-0122399 | A1 | 29 May 2008 | CN | 101192757 | A | 04 June 2008 |
| | | | | CN | 101192757 | B | 25 April 2012 |
| | | | | JP | 2008-136330 | A | 12 June 2008 |
| | | | | JP | 4782663 | B2 | 28 September 2011 |
| | | | | US | 8111035 | B2 | 07 February 2012 |

Form PCT/ISA/210 (patent family annex) (July 2022)

**EP 4 773 463 A1**

**Patent documents cited in the description**

- KR 1020240068449

- KR 1020170021630